(19) **Europäisches Patentamt / European Patent Office / Office européen des brevets**

(11) **EP 2 609 142 B1**

(12) # EUROPÄISCHE PATENTSCHRIFT

(45) Veröffentlichungstag und Bekanntmachung des Hinweises auf die Patenterteilung:
**12.10.2016 Patentblatt 2016/41**

(21) Anmeldenummer: **11743079.3**

(22) Anmeldetag: **12.08.2011**

(51) Int Cl.:
*C09D 7/00* (2006.01)    *C08K 3/22* (2006.01)
*C09D 127/16* (2006.01)    *H01L 41/37* (2013.01)
*C08J 3/215* (2006.01)    *C08J 3/09* (2006.01)
*C08J 3/11* (2006.01)    *H01L 41/45* (2013.01)
*H01L 41/317* (2013.01)

(86) Internationale Anmeldenummer:
**PCT/EP2011/063977**

(87) Internationale Veröffentlichungsnummer:
**WO 2012/025412 (01.03.2012 Gazette 2012/09)**

(54) **FLUORPOLYMERHALTIGE LÖSUNG ODER SUSPENSION, VERFAHREN ZU IHRER HERSTELLUNG SOWIE IHRE VERWENDUNG BEI DER HERSTELLUNG VON PIEZO- UND PYROELEKTRISCHE SCHICHTEN**

SOLUTION OR SUSPENSION OF FLUOROPOLYMERS, PROCESS FOR MAKING THEM AS WELL AS THEIR USE FOR THE PREPARATION OF PIEZOELECTRIC AND PYROELECTRIC LAYERS

SOLUTION OU SUSPENSION DE POLYMÈRES À BASE DE FLUOR, PROCÉDÉ POUR LEUR PRÉPARATION AINSI QUE LEUR UTILISATION POUR LA PRÉPARATION DE COUCHES PIEZO- ET PYROÉLECTRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.08.2010 EP 10174424**

(43) Veröffentlichungstag der Anmeldung:
**03.07.2013 Patentblatt 2013/27**

(73) Patentinhaber:
• **Fraunhofer-Gesellschaft zur Förderung der angewandten Forschung e.V.
80686 München (DE)**
• **Joanneum Research Forschungsgesellschaft mbH
8010 Graz (AT)**

(72) Erfinder:
• **BAUER, Siegfried
A-4040 Linz (AT)**
• **DOMANN, Gerhard
97204 Höchberg (DE)**
• **HELBIG, Uta
90403 Nürnberg (DE)**
• **KRAUSE, Markus
A-4203 Altenberg (AT)**

• **STADLOBER, Barbara
A-8044 Graz (AT)**
• **ZIRKL, Martin
8200 Gleisdorf (AT)**

(74) Vertreter: **Strehl Schübel-Hopf & Partner
Maximilianstrasse 54
80538 München (DE)**

(56) Entgegenhaltungen:
**EP-A1- 2 495 273        EP-A1- 2 579 369
EP-B1- 1 769 544        US-A1- 2004 131 862
US-A1- 2008 182 154**

• **ZENG R., KWOK K.W.,CHAN H.L.W.,CHOY C.L.: "Longitudinal and transverse piezoelectric coefficients of lead zirconate titanate/vinylidene fluoride-trifluoroethylene composites with different polarization states", JOURNAL OF APPLIED PHYSICS, Bd. 92, Nr. 5, 1. September 2002 (2002-09-01), Seiten 2674-2679, XP002608513,**

- DIETZE ET AL: "Structural and functional properties of screen-printed PZT-PVDF-TrFE composites", SENSORS AND ACTUATORS A, ELSEVIER SEQUOIA S.A., LAUSANNE, CH, Bd. 143, Nr. 2, 22. November 2007 (2007-11-22), Seiten 329-334, XP022576755, ISSN: 0924-4247 in der Anmeldung erwähnt
- JINHUA L.,NINGYI Y.,CHAN H.L.W.: "Preparation of PCLT/P(VDF-TrFE) pyroelectric sensor based on plastic film substrate", SENSORS AND ACTUATORS A, Bd. 100, 1. April 2002 (2002-04-01), Seiten 231-235, XP002608514, in der Anmeldung erwähnt
- ZIRKL M ET AL: "Synthesis of ferroelectric poly(vinylidene fluoride) copolymer films and their application in integrated full organic pyroelectric sensors", JOURNAL OF NANOSCIENCE AND NANOTECHNOLOGY, AMERICAN SCIENTIFIC PUBLISHERS, US, Bd. 353, 1. Januar 2007 (2007-01-01), Seiten 173-185, XP008093781, ISSN: 1533-4880 in der Anmeldung erwähnt
- TAZAKI MICHIKO; WADA RISEI; OKABE MASARU; HOMMA TERUTAKE: "Crystallization and gelation of poly(vinylidene fluoride) in organic solvents", JOURNAL OF APPLIED POLYMER SCIENCE, Bd. 65, 22. August 1997 (1997-08-22), Seiten 1517-1524, XP002608515,
- DATABASE WPI Week 199904 Thomson Scientific, London, GB; AN 1999-040780 XP002608516, & JP 10 298298 A (KUREHA CHEM IND CO LTD) 10. November 1998 (1998-11-10)

**Beschreibung**

Die vorliegende Erfindung betrifft eine homogene, fluorpolymerhaltige Lösung, deren Polymere in kristallinem Zustand piezo- und pyroelektrische Eigenschaften aufweisen können und in der zusätzlich ein partikelförmiges piezo- und pyroelektrisches anorganisches Material suspendiert vorliegen kann, sowie ein Verfahren zu ihrer Herstellung. Die Polymerlösung eignet sich zur großflächigen Herstellung von ggf. flexiblen, piezo- und pyroelektrischen Schichten über Rakel- oder Siebdruckverfahren.

Piezo- und pyroelektrische Materialien verknüpfen Deformationen bzw. Temperaturänderungen mit Änderungen der elektrischen Ladungsverteilung. Es sind anorganische piezo- und pyroelektrische Keramiken und Einkristalle sowie organische Polymere bekannt, darunter z. B. Rohrzucker und - vor allem - Fluorpolymere. Die Materialien, deren einzelne Kristallite jeweils schon piezo- und pyroelektrisch sein können, erhalten ihre entsprechenden makroskopischen Eigenschaften ggf. durch einen Polungsschritt, der die uneinheitliche Orientierung der Kristallite kompensiert. Letztere Materialien werden als ferroelektrisch bezeichnet. Anorganische Materialien weisen hohe piezo- und pyroelektrische Koeffizienten auf, haben jedoch den Nachteil hoher Sprödigkeit und hoher akustischer Impedanz. Anorganische piezo- und pyroelektrische Materialien können als kompakte Keramiken oder als Dünnschichten hergestellt werden.

Bauteile aus piezo- und pyroelektrischen Keramiken werden über Sinterprozesse hergestellt, die hohe Temperaturen erfordern. Die hohen Verarbeitungstemperaturen beschränken bei der Synthese von Dünnschichten die Auswahl von Substraten. Bei Verwendung spezieller Methoden wie beispielsweise des Sol-Gel-Verfahrens in Kombination mit Mikrowellen- oder Lasersinterung können die Temperaturen zwar gesenkt werden; um hinreichend gute Materialeigenschaften zu erzielen, müssen aber im Allgemeinen etwa 500°C erreicht werden.

Von einer Reihe von halogenierten Polymeren wie PVC (Polyvinylchlorid), PVF (Polyvinylfluorid) und insbesondere PVDF (Polyvinylidenfluorid) ist bekannt, dass sie in bestimmten kristallinen Konformationen piezoelektrische, pyroelektrische und meist auch ferroelektrische Eigenschaften besitzen. Solche Eigenschaften haben auch viele Copolymere dieser Materialien, z.B. P(VDF/TFE) (TFE steht für Tetrafluorethylen), P(VDF/HFP) (HFP steht für Hexafluorpropylen) P(VDF/TrFE) (TrFE steht für Trifluorethylen), P(VDF-CTFE) (CTFE steht für Chlortrifluorethylen) oder P(VDF/HFP/TFE). Der Zusatz insbesondere kleinerer Mengen von TrFE oder TFE und dergleichen zu PVDF begünstigt die direkte Kristallisation der Fluoropolymeren in die β-Phase aus der Schmelze. Diese Phase besitzt die genannten Eigenschaften. Auch ist bei Zusatz solcher Comonomere ein späteres Verstrecken der Folie nicht nötig, wie es bei PVDF-Homopolymeren der Fall ist.

Die piezo- und pyroelektrischen Polymere sind flexibel, besitzen eine für Impedanzanpassungen vorteilhafte geringe Dichte, haben aber vergleichsweise niedrige piezo- und pyroelektrische Koeffizienten, wobei diese Koeffizienten stark von der jeweils erzielbaren Kristallstruktur bzw. von dem Anteil an kristalliner Struktur im Polymer abhängen. Die piezoelektrischen Eigenschaften von PVDF sind allerdings immerhin mehr als zehnmal so hoch wie die von Quarz. Üblicherweise werden Bauteile aus organischen piezo- und pyroelektrischen Materialien aus Folien hergestellt. Erhöhte Temperaturen sind dabei nur soweit erforderlich, als das Material in Lösung gebracht und das Lösungsmittel ausschließend wieder entfernt werden muss.

Bereits in den 70er Jahren des vorigen Jahrhunderts wurde versucht, anorganische und organische piezo- und pyroelektrische Materialien und damit deren jeweils vorteilhaften Eigenschaften miteinander zu verknüpfen. Herstellungsverfahren, Messmethoden und Modelle zur Berechnung von Eigenschaftsprofilen wurden entwickelt, siehe Das-Gupta, D.K. (Hrsg.): Ferroelectric Polymers and Ceramic-Polymer Composites. Trans Tech Publications Ltd., Schweiz, 1994. Ein übliches Verfahren zur Herstellung von PVDF-PZT-Kompositen ist das Mischen der beiden Komponenten in einem Walzwerk oder die Zugabe der anorganischen Komponente in eine Polymerlösung (siehe J. Zeng, Appl. Phys. 9 (2002), 2674-2679; Das-Gupta, a.a.O.; L. Jinhua et al., Preparation of PCLT/P(VDF-TrFE) pyroelectric sensor based on plastic film substrate, Sensors and Actuators A 100 (2002) 231-235; EP 1769544 A1) und eine eventuelle Nachbehandlung durch Heißpressen.

Die Kombination eines ferroelektrischen Polymers mit einer ferroelektrischen Keramik eröffnet die Möglichkeit, Materialien herzustellen, die entweder nur piezo- oder nur pyroelektrisch sind. Durch ein spezielles Polungsverfahren können die Polarisationsrichtungen beider Komponenten parallel oder antiparallel eingestellt werden. Dadurch wird der piezo- oder pyroelektrische Effekt entweder kompensiert oder verstärkt (I. Graz et al., Flexible active-matrix cells with selectively poled bifunctional polymerceramic nanocomposite for pressure and temperature sensing skin, Journal of Applied Physics 106, 034503 (2009).

Für PVC, PVF und PVDF sowie deren Copolymere ist eine ganze Reihe von mehr oder weniger guten Lösungsmitteln bekannt. Dazu gehören cyclische Ether wie THF (Tetrahydrofuran) und GBL (γ-Butyrolacton; Dihydrofuran-2-on), aliphatische Ketone wie Aceton, Methylethylketon, 3-Pentanon oder 3-Hexanon, cyclische Ketone wie Cyclohexanon, Methylcyclohexanon oder Isophoron, halogenierte Kohlenwasserstoffe wie Trichlorethan oder Chlordifluormethan, Ester wie Propylencarbonat sowie Triethylphosphat, N-Methylpyrrolidon, Dimethylformamid und Dimethylsulfoxid. Das piezo- und pyroelektrische Material Polyvinylidenfluorid und dessen Copolymere lässt sich beispielsweise in Aceton, N-Methylpyrrolidon oder Dimethylformamid auflösen. Insgesamt ist bei einer Betrachtung der Löslichkeitseigenschaften solcher Fluorpolymere festzustellen, dass in der Regel diejenigen Lösungsmittel, die einen relativ niedrigen Siedepunkt und entsprechend einen relativ hohen Dampfdruck aufweisen, bessere Lösungsmittel als die höhersiedenden / weniger flüchtigen sind. Für die Verwendung einer Polymerlösung in einer Rakel- und insbesondere in einer Siebdruckanlage sollte das Lösungsmittel jedoch einen niedrigen Dampfdruck bzw. einen relativ hohen Siedepunkt aufweisen, damit es nicht vor der Zeit aus der zu rakelnden / zu druckenden Lösung abdampft und damit deren rheologische Eigenschaften bzw. die Gelöstheit des Polymer negativ beeinflusst. Außerdem ist es natürlich wünschenswert, mit möglichst wenig toxischen Lösungsmitteln zu arbeiten, da Druckprozesse meist an größeren Substraten, z.B. von der Rolle, verarbeitet werden und die entsprechenden Hallen zwar Absaugungen aufweisen, aber natürlich gegebenenfalls erforderliche Arbeitsschutzmaßnahmen im Großraum wesentlich schwerer zu realisieren sind als in kleinen, verschließbaren Anlagen. Daher ist bisher kein Lösungsmittel aufgefunden worden, das gleichzeitig die erforderliche Löslichkeit für das entsprechende Fluorpolymer, einen sehr geringen Dampfdruck und eine geringe Toxizität aufweist.

Man hat sich daher damit begnügen müssen, mit relativ schlecht lösenden Lösungsmitteln zu arbeiten. GBL beispielsweise hat einen relativ niedrigen Dampfdruck (0,4 hPa bei 20°C) und einen Siedepunkt von 204-206°C und ist außerdem nicht toxisch. Deshalb hat man seine Eigenschaften als Lösungsmittel für PVDF und dessen Copolymere recht genau untersucht. Dabei stellte sich heraus, wie aus M. Zirkl et al., Ferroelectrics 353, 173-185 (2007) und M. Zirkl, Herstellung und Charakterisierung von ferroelektrischen Polymer-Dünnfilmen und ihre Anwendung in integrierten organischen Infrarotsensoren, Univ.-Diss. Graz, Österreich, 2007 bekannt, dass P(VDF-TrFE) in GBL bei erhöhter Temperatur (180°C) bis zu einem gewissen Grad löslich ist. Die beschriebene Methode hat jedoch den Nachteil, dass beim Zusammengeben des Fluorpolymeren und GBL eine sehr zähe Mischung entsteht, die sich kaum rühren lässt, so dass eine Homogenisierung sehr problematisch ist. Das Produkt ist daher meist zweiphasig und außerdem gelblich; selbst dann, wenn man die Phasen zur Lösung ineinander bringt, bleibt die gelbliche Färbung erhalten. Tazaki et al. beschreiben in J. Appl. Polym. Sci. 65(8), 1517-1524 (1997), dass sich PVDF bei 180°C u.a. in GBL auflösen lässt. Beim Abkühlen der GBL-Lösung entstand ein Gel, das beim Wiederaufwärmen thermoreversibel in ein Sol überging. Es bildete sich nach den Angaben der Autoren die Kristallstruktur vom $\gamma$-Typ (TTTGTTTG-Konformation), die für die Zwecke der vorliegenden Erfindung nicht von Interesse ist, während in Cyclohexanon die $\beta$-Phase entstand und in Dimethylformamid gar keine Gelbildung erfolgte, die nach Angabe der Autoren durch die Kristallisation des Polymeren verursacht ist. Die Synthese einer Lösung definierter Konzentration und somit definierter Viskosität ist demnach zumindest für standardisierte Prozesse, wie man sie benötigt, erschwert.

Lösungsbasierte druckbare Kompositvorstufen werden in M. Dietze et al., Sensors and Actuators A 143 (2008) 329-334 beschrieben. Als Lösungsmittel wird hier jedoch Dimethylformamid, eine toxische Substanz, verwendet.

Aus der Literatur ist bekannt, dass es für das Lösen von Lacken ganz allgemein hilfreich sein kann, mehrere Lösungsmittel einzusetzen, wobei dasjenige Lösungsmittel, das den höchsten Siedepunkt besitzt, alle Ausgangsmaterialien in dem Lack am besten lösen können muss. Neben diesem "aktiven" oder "wahren" Lösungsmittel können Colösemittel ("latent solvents") eingesetzt werden, die nur in Gegenwart des aktiven Lösungsmittels wirksam sind, siehe z.B. "Paints, Coatings, and solvents" von Dieter Stoye und Werner Freitag (Hrsg.), Wiley-VHC Verlag GmbH Weinheim/Deutschland 1998, Second completely revised edition (Reprint 2001). Ein niedrig siedendes Lösungsmittel, z.B. Aceton, wird auch häufig als Hilfsmittel bei der Herstellung einer Polymer-Dispersion eingesetzt, wobei die Ausgangskomponenten darin gelöst werden und anschließend, nach dem Polymeraufbau, dieses Lösungsmittel durch ein Dispergiermittel, z.B. Wasser, ersetzt und durch Destillation entfernt wird, siehe z.B. EP 849 298 A1, worin die Herstellung einer Polyurethandispersion mit Hilfe dieser Methode beschrieben ist. In solchen Fällen wird das niedrig siedende Lösungsmittel aber nicht als Colösemittel eingesetzt. Für PVDF wurde der Einsatz eines Colösemittels (CHClF$_2$) bisher nur im Zusammenhang mit der Verwendung von überkritischem CO$_2$ beschrieben, siehe H.-S Byun et al., Korean J. Chem. Eng. 21(6), 193-1198 (2204). Aufgabe der vorliegenden Erfindung ist es, ein Verfahren bereitzustellen, mit dessen Hilfe man klare, homogene Lösungen von Fluorpolymeren in hochsiedenden Lösungsmitteln erhalten kann, die anschließend z.B. mit drucktechnischen Methoden in pyroelektrisch und piezoelektrisch aktive Schichten überführt werden können.

Gelöst wird die Aufgabe dadurch, dass das zu lösende Fluorpolymer, ausgewählt unter Fluor-Homo- und Copolymeren und Gemischen verschiedener Fluor-Homo- und/oder Copolymeren, insbesondere unter PVDF oder einem Copolymer aus VDF und einem weiteren Fluormonomeren, in einem Gemisch aus mindestens zwei Lösungsmitteln gelöst wird, dessen erstes ein niedrigsiedendes Lösungsmittel mit einem Siedepunkt von unter 150°C, bevorzugt unter 100°C und besonders bevorzugt unter 75°C und/oder einem Dampfdruck von über 5 hPa, bevorzugt über 25 hPa und stärker bevorzugt über 100 hPa bei 20°C ist und dessen zweites ein hochsiedendes Lösungsmittel (mit einem Siedepunkt von vorzugsweise über 180°C und/oder einem Dampfdruck von unter 3, vorzugsweise von unter 1 hPa) ist. Die Differenz der Siedetemperatur zwischen dem ersten und dem zweiten Lösungsmittel wird dabei so gewählt, dass der Trennfaktor $\alpha \geq 1$ sein kann und vorzugsweise (um die Wirtschaftlichkeit des Verfahrens günstig zu gestalten) $\geq 1,04$ ist. Dieser Faktor errechnet sich unter der Voraussetzung nahezu idealen Verhaltens der Lösungsmittel nach

$$\log \alpha_{1,2} = \frac{T_{S2}^* - T_{S1}^*}{T_M} \cdot \left( 7,30 - 0,662 \cdot \log p_{tot} + \frac{T_M}{103 \cdot \log p_{tot}} \right)$$

$\alpha_{1,2}$    "relative Flüchtigkeit" oder "Trennfaktor"

$T_{S2}^*$    Siedepunkt schwer flüchtige Komponente

$T_{S1}^*$    Siedepunkt leicht flüchtige Komponente

$T_M$    Siedepunkt des Gemisches

$p_{tot}$    Druck im System bei der Destillation

Da Angaben für die Trennbarkeit über eine nur einfache Destillation aus der Literatur häufig nicht eindeutig zu entnehmen sind, muss in den Fällen, in denen nicht sichergestellt werden kann, dass der Trennfaktor $\alpha \geq 1$ beträgt, der Siedepunkt des hochsiedenden Lösungsmittels um mindestens 50°K höher liegt als der des ersten Lösungsmittels. Selbstverständlich ist es möglich, dass sich dabei der gewünschte Trennfaktor einstellt. In bevorzugten Fällen liegt die Siedepunktdifferenz bei ≥60°K, stärker bevorzugt bei ≥70°K und ganz bevorzugt bei ≥80°K, weil dann eine Trennung bereits über eine einfache Destillation möglich ist. Wenn das Fluorpolymer vollständig gelöst ist, wird das erste Lösungsmittel im Wesentlichen oder vollständig entfernt. "Im Wesentlichen" soll in diesem Zusammenhang bedeuten, dass nicht mehr mehr als 5 Vol.-%, stärker bevorzugt nicht mehr als 2 Vol.-% dieses Lösungsmittels im Gemisch verbleiben.

In einer bevorzugten Ausführungsform sind beide Lösungsmittel nur wenig oder nicht toxisch. Unter diesem Ausdruck soll zu verstehen sein, dass sie nicht als "sehr giftig", "giftig", "krebserzeugend", "erbgutverändernd" oder "reproduktionstoxisch (fortpflanzungsgefährdend)" im Sinne der deutschen Verordnung zum Schutz vor Gefahrstoffen (Gefahrstoffverordnung - GefStoffV) bzw. einer entsprechenden europäischen Verordnung (CLP-Verordnung (EG) Nr. 1272/2008) oder US-amerikanischen Richtlinie in eine der Gefahrenklassen "Akute Toxizität Kategorie 1 bis 3", "Karzinogenität", "Keimzellmutagenität", oder "Reproduktionstoxizität" eingestuft sind und dann, wenn sie relativ hoch flüchtig sind, einen Arbeitsplatzgrenzwert nach der Verordnung "Technische Regeln für Gefahrstoffe" (TRGS 900) von mindestens 200 mg pro m$^3$ und/oder - in allen Fällen - eine $LD_{50}$, gemessen an der Ratte, von nicht unter 200 mg/kg (GefStoffV) beziehungsweise 300mg/kg (CLP-Verordnung) aufweisen dürfen.

In einer davon unabhängigen bevorzugten Ausführungsform werden die mindestens zwei Lösungsmittel zuerst miteinander gemischt, und erst dann wird das Polymer, z.B. als Pulver oder in Granulatform, zugegeben.

Das zu lösende Fluorpolymer (z.B. PVDF oder ein Copolymer davon) wird demnach in Form eines Pulvers, eines Granulats oder dergleichen in mindestens zwei Lösungsmitteln gelöst, deren erstes ein niedrig siedendes gutes Lösungsmittel ist und deren zweites ein hoch siedendes, weniger gut lösendes Lösungsmittel ist. Vorzugsweise geschieht dies dadurch, dass das Fluorpolymer in eine Mischung der genannten Lösungsmittel eingebracht wird. Durch anschließendes Rühren entsteht eine klare homogene Lösung. Das Rühren erfolgt dabei vorzugsweise bei relativ milden Temperaturen, z.B. in günstiger Weise bei Raumtemperatur oder bis zu ca. 25°K darüber. Erfolgt die Herstellung dagegen bei Temperaturen in der Nähe des Schmelzpunktes des Polymers (der für PVDF bei 176°C und für ein Copolymer aus PVDF und TrFE im molaren Verhältnis von 70:30 bei 154,5°C liegt, kann dies die Reproduzierbarkeit der Herstellung bei manchen Mischungen in ungünstiger Weise beeinflussen. Anschließend wird das niedrig siedende Lösungsmittel bei möglichst nicht oder nur wenig erhöhter Temperatur (beispielsweise 40°C) und ggf. Unterdruck aus dem Gemisch entfernt. Danach liegt eine klare homogene farblose Lösung vor, deren Viskosität über den Polymergehalt eingestellt werden kann.

Werden ausschließlich die genannten zwei Lösungsmittel eingesetzt, verwendet man diese vorzugsweise im Verhältnis von zwischen 80:20 und 20:80 (Vol./Vol.), stärker bevorzugt im Verhältnis von zwischen 65:35 und 35:65 (Vol./Vol). und ganz besonders bevorzugt im Verhältnis von zwischen 45:55 und 55:45 (Vol./Vol.). Man kann sie beispielsweise im Verhältnis von 1:1 (Vol./Vol.) einsetzen.

Als niedrig siedendes gutes Lösungsmittel (als Colöser) eignen sich z.B. Aceton mit einem Sdp. von 56°C, Tetrahydrofuran mit einem Sdp. von 66°C, Trichlorethan mit einem Siedepunkt von 74°C und Cyclopentylmethylether (Sdp. 106°C). Aceton ist darunter aus Gründen des Gesundheitsschutzes besonders bevorzugt.

Als hoch siedendes, intermediäres Lösungsmittel kann beispielsweise DMSO (Sdp. 189°C), Triethylphosphat (Sdp- 215°C), $\gamma$-Butyrolacton, N-Methylpyrrolidin (Sdp. 203°C), ein cyclisches Keton wie Cyclohexanon (Sdp. 156°C), Cyclopentanon (Sdp. 131°C, Dampfdruck 11 hPa), 3-Methylcyclohexanon (Sdp. 162-163°C) oder Menthon-trans-2-isopropyl-5-methylcyclohexanon oder eine Mischung von zweien oder mehr dieser Lösungsmittel eingesetzt werden. Für den Fall, dass das niedrig siedende Lösungsmittel einen relativ geringen Siedepunkt hat, kann als hoch siedendes Lösungsmittel auch ein solches mit einem relativ geringen Siedepunkt eingesetzt werden wie das in der Gruppe der niedrig siedenden Lösungsmittel erwähnte Cyclopentylmethylether, sofern die Siedepunkt-Differenz zwischen beiden mindestens 50K beträgt.

Besonders bevorzugt ist eine Kombination von Aceton als niedrigsiedendem Lösungsmittel und Butyrolacton als hochsiedendem Lösungsmittel.

Polymerlösungen, die ausschließlich aus Polymer und einem hochsiedenden Lösungsmittel, insbesondere $\gamma$-Butyrolacton, bestehen, sind klar und farblos. Lösungen, die unter Temperatureinwirkung hergestellt werden, zeigen hingegen eine charakteristische gelblich-grüne Färbung. Gefärbte Lösungen sollen erfindungsgemäß vermieden werden, weil sich herausgestellt hat, dass sie für die Herstellung flächiger Schichten, insbesondere durch Rakel- und Siebdruckverfahren, ungeeignet sind bzw. zu schlechteren Produkten führen.

Erfindungsgemäß ist es möglich, eine Lösung herzustellen, die zusätzlich anorganische Partikel eines piezoelektrisch und pyroelektrisch aktiven bzw. aktivierbaren Oxids (einer Oxidkeramik) enthält. Beispiele sind PZT (Blei-Zirkonat-Titanat), BTO (Bariumtitanat), PTO (Bleititanat) und BNT-BT (Bismutnatriumtitanat-Bariumtitanat). Hierfür wird zunächst eine Suspension der anorganischen Partikel in einem geeigneten, vorzugsweise niedrig siedenden Suspensionsmittel hergestellt, ggf. unter Verwendung eines üblichen Dispergierhilfsmittels. Die Wahl des Suspensionsmittels ist an sich nicht kritisch; es ist jedoch darauf zu achten, dass die Partikel gut dispergiert werden können (beispielsweise mittels Ultraschall). Hierfür eignen sich Suspensionsmittel mit einem Siedepunkt von unter 120°C, vorzugsweise von unter 100°C. Zusätzlich muss das Suspensionsmittel mit der PVDF bzw. PVDF-Kopolymer-Lösung kompatibel sein, das heißt es darf nicht zu einer Ausfällung des Polymers kommen. Geeignete Lösungsmittel hierfür sind z.B. aliphatische Ketone wie Aceton oder Methylethylketon (worunter Methylethylketon bevorzugt ist) oder Mischungen von aliphatischen Ketonen oder Mischungen eines oder mehrerer Lösungsmittel mit aliphatischen Ketonen oder manche Alkohole (Ethanol lässt sich in einer Menge von bis zu etwa 1:1 (Gew./Gew.) mit einer Lösung des fluorierten Polymer in GBL mischen). Die Partikelsuspension kann entweder dem Zwischenprodukt, d.h. der aus Polymer und Lösungsmittelgemisch bestehenden Lösung, oder der Polymerlösung zugesetzt werden, aus der das niedersiedende Lösungsmittel bereits entfernt wurde. Die im letzteren Fall entstehende Suspension besitzt in der Regel eine niedrige Viskosität, die durch zusätzliche Zugabe eines niedrig siedenden Lösungsmittels (insbesondere eines der oben für die erfindungsgemäße Herstellung erwähnten) ggf. weiter verringert werden kann, so dass ein Dispergieren der Partikel in der Polymerlösung mit geeigneten Methoden sehr gut durchgeführt werden kann (beispielsweise durch Ultraschallbehandlung). Anschließend wird der Anteil an Suspensionsmitteln und ggf. an niedrig siedendem Lösungsmittel wie oben beschrieben entfernt. Dadurch steigt die Viskosität der Lösung wieder an, so dass die Sedimentation der Partikel gehemmt wird. Für diesen Arbeitsschritt ist eine kurze Zeitdauer vorteilhaft, um die Dispersion der Partikel zu erhalten.

In einer spezifischen Ausführungsform der Erfindung wird die Suspension unter Zuhilfenahme von Aceton als erstem Lösungsmittel, Butyrolacton als zweitem Lösungsmittel und einem aliphatischen Keton mit einem Siedepunkt von unter 120°C, vorzugsweise Methylethylketon, hergestellt.

Aus einer derartigen Lösung, die nachstehend auch als Kompositvorstufe bezeichnet wird, kann ein Kompositmaterial mit den oben beschriebenen Eigenschaften hergestellt werden.

Die erfindungsgemäße Polymerlösung und bzw. die erfindungsgemäße Kompositvorstufe können u.a. auf ein Substrat aufgeschleudert, gerakelt oder auf einem Siebdrucker verarbeitet werden. Zum Aushärten der Schicht durch Entfernen des Lösungsmittels ist eine thermische Nachbehandlung erforderlich (in der Regel bei etwa 90°C-110°C; die Dauer dieser Nachbehandlung ist nicht kritisch und liegt in der Regel bei 5 min bis 5h). Die resultierenden ferroelektrischen Schichten erhalten durch einen anschließenden Polungsschritt ihren piezo- und pyroelektrischen Eigenschaften.

Die Erfindung zeichnet sich dadurch aus, dass sich die Polymerlösung während der Herstellung mit einem Magnetrührer problemlos durchmischen lässt. Es entsteht eine klare, farblose, homogene Lösung, deren Viskosität durch den Polymergehalt eingestellt werden kann. Dadurch lassen sich unproblematisch große Mengen an homogenen Lösungen geeigneter Viskosität herstellen, die anschließend für Druckprozesse oder dergleichen eingesetzt werden können, weil sich ihre Fließeigenschaften während des Druckprozesses nicht durch vorzeitiges Abdampfen von Lösungsmittel verändern. Außerdem wird die Umwelt weniger durch Lösungsmitteldämpfe belastet. Insbesondere dann, wenn wenig toxische oder völlig unbedenkliche Lösungsmittel als intermediäres Lösungsmittel eingesetzt werden, ergeben sich zusätzliche Vorteile unter gesundheitlichen Aspekten für die mit den Druck- oder sonstigen Weiterverarbeitungsprozessen befassten Menschen. Ein weiterer Vorteil liegt darin, dass die Lösung des Polymers bei Raumtemperatur erreicht werden kann. Das aus dem Lösungsmittelgemisch entfernte Colösemittel kann rückgewonnen und für die erfindungsgemäße Herstellung wiederverwendet werden.

Bei der Verwendung von Colösern zur Herstellung von Polymerlösungen nach dem Stand der Technik wie oben erläutert verbleibt das Colösemittel im Allgemeinen im Gemisch. Aus den bisher bekannt gewordenen Untersuchungen zur Herstellung von P(VDF-TrFE)-Schichten für den Einsatz als Sensoren weiß man, dass es besonders vorteilhaft für dieses Polymer ist, ausschließlich $\gamma$-Butyrolacton als Lösungsmittel zu verwenden (siehe M. Zirkl und M. Zirkl et al., a.a.O.). Die Art des Lösungsmittels bzw. des Lösungsmittelgemisches beeinflusst die Dichte und die Kristallinität und damit die elektronischen Eigenschaften des nach dem Abdampfen des Lösungsmittels erhaltenen Feststoffs. Dabei gilt, dass leicht flüchtige Lösungsmittel die Dichte des Polymer verringern bzw. "Cavities" beim Verdampfen verursachen. Auch steigt die Kristallinität bei nur langsamer Verdampfung an, was ein weiterer Grund für die erfindungsgemäß vorgeschlagene Verwendung eines hochsiedenden Lösungsmittels ist. Die Entfernung des Colösemittels, z.B. des Acetons, aus dem Gemisch nach dem erfindungsgemäßen Verfahren ermöglicht somit z.B. die Herstellung von klaren, farblosen PVDF-Lösungen in reinem γ-Butyrolacton oder von sonstigen Fluorpolymeren in ausschließlich einem hochsiedenden Lösungsmittel. Mit solchen Lösungen lassen sich qualitativ wesentlich hochwertigere Fluorpolymerschichten (wie z. B. P(VDF-TrFE)-Schichten aus GBL) herstellen als aus dem Stand der Technik bekannt. Über druckbare Vorstufen für piezo-und pyroelektrische Kompositmaterialien wird beispielsweise in K.I. Arshak et al., Sensors and Actuators 79 (2000) 102-114, oder Y.H. Son et al., Integrated Ferroelectrics, 88 (2007) 44-50 berichtet. In beiden Fällen handelt es sich bei den Vorstufen jedoch um Partikelsuspensionen, für die ein Nachbehandlungsschritt bei hohen Temperaturen (laut Arshak et al. 170°C, d.h. oberhalb der Schmelztemperatur von PVDF:TrEF (70:30), s.o.) erforderlich sein kann. Resultierende piezo- und pyroelektrische Eigenschaften werden in keiner der beiden Veröffentlichungen beschrieben. Es sind jedoch aufgrund der schlechteren Homogenität der aufgebrachten Schichten im Vergleich zu solchen aus lösungsbasierten Materialien schlechtere Eigenschaftsprofile, insbesondere schlechtere elektronische Eigenschaften, zu erwarten.

Der Vorteil des erfindungsgemäßen Verfahrens besteht in der Verwendung eines in der Regel ungiftigeren Lösungsmittels, der Möglichkeit, Partikel ohne weitere Vorbehandlung einarbeiten zu können, und in den guten piezo- und pyroelektrischen Eigenschaften des resultierenden Materials. Zusätzlich ermöglicht das Verfahren die definierte Einstellung der Viskosität und damit die Anpassung an das Applikationsverfahren, da die Viskosität der Vorstufe hauptsächlich durch den Gehalt an Polymer und somit durch die Einwaage bestimmt wird.

Ausführungsbeispiel 1 (Polymerlösung)

- Vorlegen von 250 ml γ-Butyrolacton (GBL) und 250 ml Aceton in 1 L Einhalskolben
- ca. 1 min Rühren mit einem Magnetrührer
- Einwiegen von 61,9 g P(VDF-TrFE)-Granulat
- Zugeben des Granulats zum Lösungsmittelgemisch unter Rühren
- 24 h Rühren bei Raumtemperatur (Ergebnis: klare farblose Flüssigkeit)
- Abrotieren von Aceton aus Gemisch (Gesamtdauer ca. 5 h)
- bei 40 °C bei einem Druck zwischen 250 mbar und 2-3 mbar

Ergebnis: klare, farblose Lösung mit einer Viskosität von etwa 25 Pa s (bei Raumtemperatur und einer Scherrate von $10 \text{ s}^{-1}$)

Gemäß diesem Ausführungsbeispiel können Lösungen mit unterschiedlichen Fluorpolymergehalten hergestellt werden, indem mehr oder weniger P(VDF-TrFE)-Granulat eingewogen wird.

Ausführungsbeispiel 2 (Kompositvorstufe)

Herstellen der Partikel-Suspension:

- Suspendieren von beispielsweise 0,5g $PbTiO_3$-Pulver in 50 ml Methylethylketon, Ultraschallbehandlung für 1 h,
- 1 h sedimentieren lassen,
- Abpipettieren von ca. 30 g Suspension
- Eintrocknen der Suspension, Bestimmen des Gewichts des Rückstands (Beispiel: 2,3g)
- Erneutes Suspendieren des $PbTiO_3$-Pulvers in Methylethylketon (Beispiel: 30 ml) durch Ultraschallbehandlung (1 h)

Herstellen der Kompositvorstufe:

- Zugabe der Suspension zu einer entsprechenden Menge (Beispiel: 30g) an Polymerlösung, hergestellt nach Ausführungsbeispiel 1
- Ultraschallbehandlung für 1 h
- Abziehen von Methylethylketon aus dem Gemisch (Rotationsverdampfer bei 40°C)

Ergebnis: weiße opake Suspension mit einer Viskosität von etwa 25 Pa s bei Raumtemperatur und einer Scherrate von $10 \text{ s}^{-1}$

Ausführungsbeispiel 3 (Kompositvorstufe)

Das Ausführungsbeispiel 2 wurde mit der Änderung wiederholt, dass anstelle von $PbTiO_3$ Bismutnatriumtitanat-Bariumtitanat (BNT-6BT) eingesetzt wurde.

Ausführungsbeispiel 4 (Kompositvorstufe)

Das Ausführungsbeispiel 3 wurde mit der Änderung wiederholt, dass anstelle von 30g Suspension 40g Suspension eingesetzt wurde. Die Viskosität änderte sich dadurch nicht.

Ausführungsbeispiel 5 (Kompositvorstufe)

Vergleichsbeispiel

- Erhitzen von 25ml GBL in einem Dreihalskolben auf 180°C unter Verwendung eines Rückflusskühlers.
- Einwiegen von 18 Gew.% PVDF:TrFE Granulat (5,076 g)
- Sukzessives Zugeben des Granulats zum Lösemittel unter Rühren mit einem Magnetrührer
- 2-3 h Rühren unter dem Rückflusskühler bei 180°C
- Abkühlen der Lösung auf < 100°C
- Abfüllen der Lösung und Abkühlen auf Raumtemperatur

Ergebnis: gelbliche Lösung mit einer Viskosität von beispielsweise etwa 40 Pa s (bei Raumtemperatur und einer Scherrate von 10 s$^{-1}$)

Die nach dem erfindungsgemäßen Verfahren synthetisierten Lösungen können zur Herstellung von Sensorschichten eingesetzt werden. Die hierfür gewählten Techniken sind nicht kritisch; beispielsweise können Rakel-, Druck- oder Nassbeschichtungsverfahren wie z.B. Schleudern, Tauchen oder Sprühen verwendet werden. Solche Sensoren können beispielsweise im Bereich Human Machine Interface, als sogenannte "elektronische Haut" und im Bereich der Überwachung von Gebäuden oder Anlagen verwendet werden. Nachstehend wird beispielhaft ein Druckverfahren beschrieben:

Die Lösung des Beispiels 1 wird unter Verwendung einer Siebdruckanlage üblicher Bauart, z.B. des halbautomatischen Siebdruckers EKRA X1 verdruckt. Für den Druckprozess wird ein Sieb aus Polyestergewebe mit einer Gewebefeinheit von 110-34 cm/DIN (110 Fäden pro cm bei einer Fadendicke von 34 $\mu$m) und ein Rakel aus Polyurethangummi, Shore-Härte 65 verwendet. Die Lösung wird als Druckfarbe aufgetragen. Nach dem Druck unter Verwendung üblicher Parameter erfolgt die Härtung der Schicht durch eine thermische Nachbehandlung bei einer Temperatur zwischen 90°C und 110°C für eine Dauer von 5 min bis 5 h.

Die Eigenschaften der Schicht wurden an einer Probe wie folgt gemessen:

- Remanente Polarisation: 5-8 $\mu$C/cm$^2$
- Pyroelektrischer Koeffizient (RT): 40 $\mu$C/m$^2$K
- Piezoelektrischer Koeffizient ($d_{33}$): 25 pC/N

Ganz allgemein ist es besonders günstig, für das Drucken Konzentrationen von zwischen etwa 15 und etwa 30 Gew.-% Fluorpolymer im Lösungsmittel vorzusehen. Im Falle der in Ausführungsbeispiel 1 genannten Materialien konnten Lösungen von bis wenig unter 30 Gew.-% Fluorpolymer für das Siebdrucken eingesetzt werden; bei 30 Gew.-% wurde die Viskosität der Lösung für dieses Verfahren zu hoch. Insbesondere mit Konzentrationen zwischen 18 und etwa 25 Gew.-% erhält man beim Siebdrucken sehr gute Qualitäten; die Schichten sind elektrisch isolierend und lochfrei.

Mit der Suspension des Beispiels 3 ließen sich rissfreie Schichten mit einer Schichtdicke von 4,7 $\mu$m drucken, mit der Suspension des Beispiels 4 ebenfalls, wobei die erzielte Schichtdicke bei 5 $\mu$m lag.

Die Arbeit, die zu dieser Erfindung führte, wurde unter "grant agreement n° [215036] durch das "European Community's Seventh Framework Programme [FP7/2007-2013] gefördert. * * *

**Patentansprüche**

1. Verfahren zum Herstellen einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, worin

   (a) das zu lösende Fluorpolymer in einer Mischung aus mindestens zwei Lösungsmitteln gelöst wird, dessen erstes einen Siedepunkt von unter 150°C, und/oder einen Dampfdruck von über 5 hPa (bei 20°C) aufweist und dessen zweites ein hochsiedendes Lösungsmittel ist, das einen um mindestens 50 °C höheren Siedepunkt aufweist als das erste Lösungsmittel und/oder dessen Siedepunkt so gewählt ist, dass die Lösungsmittel-Mischung einen Trennfaktor $\alpha$ von $\geq 1$, aufweist, und anschließend

(b) das erste Lösungsmittel aus dem Gemisch im Wesentlichen oder vollständig entfernt wird.

2.  Verfahren nach Anspruch 1, worin das erste Lösungsmittel einen Siedepunkt von unter 75°C und/oder einen Dampfdruck von über 100 hPa (bei 20°C) aufweist und das zweite Lösungsmittel einen Siedepunkt von über 180°C und/oder einen Dampfdruck von unter 3 hPa besitzt.

3.  Verfahren nach Anspruch 1 oder 2, **dadurch gekennzeichnet, dass** die mindestens zwei Lösungsmittel zuerst vermischt werden und das zu lösende Fluorpolymer in die Lösungsmittel-Mischung gegeben wird.

4.  Verfahren nach einem der voranstehenden Ansprüche, **dadurch gekennzeichnet, dass** das erste Lösungsmittel Aceton ist und dass das zweite Lösungsmittel Butyrolacton ist.

5.  Verfahren zum Herstellen einer Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, umfassend die Schritte:

    (a) Herstellen einer Suspension der anorganischen Partikel in einem Suspensionsmittel,
    (b) Lösen des Fluorpolymeren in einer Mischung aus mindestens zwei Lösungsmitteln, dessen erstes einen Siedepunkt von unter 150°C, und/oder einen Dampfdruck von über 5 hPa (bei 20°C) aufweist und dessen zweites ein hochsiedendes Lösungsmittel ist, das einen um mindestens 50 °C höheren Siedepunkt aufweist als das erste Lösungsmittel und/oder dessen Siedepunkt so gewählt ist, dass die Lösungsmittel-Mischung einen Trennfaktor $\alpha$ von $\geq 1$, aufweist,
    (c) Zugeben der Suspension der anorganischen Partikel zu der Lösung des Fluorpolymeren gemäß (b) und
    (d) vollständiges oder im Wesentlichen erfolgendes Entfernen des ersten Lösungsmittels und des Suspensionsmittels.

6.  Verfahren zum Herstellen einer Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, umfassend die Schritte:

    (a) Herstellen einer Suspension der anorganischen Partikel in einem Suspensionsmittel,
    (b) Herstellen einer Fluorpolymer-Lösung wie in einem der Ansprüche 1 bis 5 beansprucht,
    (c) Zugeben der Suspension der anorganischen Partikel zu der Lösung des Fluorpolymeren gemäß (b) und
    (d) vollständiges oder im Wesentlichen erfolgendes Entfernen des Suspensionsmittels.

7.  Verfahren nach Anspruch 5 oder Anspruch 6, **dadurch gekennzeichnet, dass** das Suspensionsmittel einen Siedepunkt von unter 120°C, vorzugsweise von unter 100°C aufweist.

8.  Verfahren nach Anspruch 7, **dadurch gekennzeichnet, dass** das Suspensionsmittel ausgewählt ist unter aliphatischen Ketonen sowie Mischungen von aliphatischen Ketonen oder Mischungen eines oder mehrerer Lösungsmittel mit aliphatischen Ketonen.

9.  Verfahren nach Anspruch 5, worin das erste Lösungsmittel einen Siedepunkt von unter 75°C und/oder einen Dampfdruck von über 100 hPa (bei 20°C) aufweist und das zweite Lösungsmittel einen Siedepunkt von über 180°C und/oder einen Dampfdruck von unter 3 hPa besitzt.

10. Verfahren nach Anspruch 9, **dadurch gekennzeichnet, dass** das erste Lösungsmittel Aceton ist, das zweite Lösungsmittel Butyrolacton ist und das Suspensionsmittel ein aliphatisches Keton mit einem Siedepunkt von unter 120°C und vorzugsweise Methylethylketon ist.

11. Farblose Suspension von anorganischen Partikeln eines piezoelektrisch und pyroelektrisch aktiven bzw. aktivierbaren Oxids in einer homogenen Lösung eines Fluorpolymeren, ausgewählt unter Fluor-Homo- und Copolymeren und Gemischen verschiedener Fluor-Homo- und/oder Copolymere, in einem hochsiedenden Lösungsmittel, das ausgewählt ist unter Lösungsmitteln mit einem Siedepunkt von über 180°C und/oder einem Dampfdruck von unter 3 hPa, wobei die Suspension nach einem Verfahren gemäß einem der Ansprüche 5 bis 10 erhältlich ist.

**12.** Verwendung einer Suspension nach Anspruch 11 zum Herstellen einer piezo- und pyroelektrische Schicht.

**13.** Verwendung nach Anspruch 12, worin die piezo- und pyroelektrische Schicht durch Rakel- oder Siebdruckverfahren gebildet wird.

**Claims**

**1.** Method for the manufacture of a homogeneous solution of a fluoropolymer, selected among fluoro-homopolymers and copolymers and mixtures of different fluoro-homopolymers and/or copolymers, in a high boiling point solvent, wherein

(a) the fluoropolymer to be dissolved is dissolved in a mixture comprising at least two solvents, the first of which has a boiling point below 150° C, and/or a vapor pressure above 5 hPa (at 20° C) and the second of which is a high boiling point solvent having a boiling point that is at least 50° C higher than the one of the first solvent and/or the boiling point of which is selected such that the solvent mixture has a separation factor $\alpha$ of $\geq 1$, and subsequently
(b) the first solvent is substantially or fully removed from the mixture.

**2.** Method according to claim 1, wherein the first solvent has a boiling point below 75° C and/or a vapor pressure above 100 hPa (at 20° C) and the second solvent has a boiling point above 180° C and/or a vapor pressure below 3 hPa.

**3.** Method according to claim 1 or 2, **characterized in that** the at least two solvents are mixed first and the fluoropolymer to be dissolved is added to the solvent mixture.

**4.** Method according to any one of the preceding claims, **characterized in that** the first solvent is acetone and the second solvent is butyrolactone.

**5.** Method for the manufacture of a suspension of inorganic particles of a piezoelectrically and pyroelectrically active or activatable oxide in a homogeneous solution of a fluoropolymer, selected among fluoro-homopolymers and copolymers and mixtures of different fluoro-homopolymers and/or copolymers, in a high boiling point solvent, comprising the steps:

(a) preparing a suspension of the inorganic particles in a suspending agent,
(b) dissolving the fluoropolymer in a mixture comprising at least two solvents, the first of which has a boiling point below 150° C, and/or a vapor pressure above 5 hPa (at 20° C) and the second of which is a high boiling point solvent having a boiling point that is at least 50° C higher than the one of the first solvent and/or the boiling point of which is selected such that the solvent mixture has a separation factor $\alpha$ of $\geq 1$,
(c) adding the suspension of the inorganic particles to the solution of the fluoropolymer according to (b) and
(d) completely or substantially removing the first solvent and the suspending agent.

**6.** Method for the manufacture of a suspension of inorganic particles of a piezoelectrically and pyroelectrically active or activatable oxide in a homogeneous solution of a fluoropolymer, selected among fluoro-homopolymers and copolymers and mixtures of different fluoro-homopolymers and/or copolymers, in a high boiling point solvent, comprising the steps:

(a) preparing a suspension of the inorganic particles in a suspending agent,
(b) preparing a fluoropolymer solution as claimed in any of claims 1 to 5,
(c) adding the suspension of the inorganic particles to the solution of the fluoropolymer according to (b) and
(d) completely or substantially removing the first solvent and the suspending agent.

**7.** Method according to claim 5 or claim 6, **characterized in that** the suspending agent has a boiling point below 120° C, preferably below 100° C.

**8.** Method according to claim 7, **characterized in that** the suspending agent is selected among aliphatic ketones as well as mixtures of aliphatic ketones or mixtures of one or a plurality of solvents with aliphatic ketones.

9. Method according to claim 5, wherein the first solvent has a boiling point below 75° C and/or a vapor pressure above 100 hPa (at 20° C) and the second solvent has a boiling point above 180° C and/or a vapor pressure below 3 hPa.

10. Method according to claim 9, **characterized in that** the first solvent is acetone, the second solvent is butyrolactone and the suspending agent is an aliphatic ketone with a boiling point below 120° C and is preferably methyl ethyl ketone.

11. Colorless suspension of inorganic particles of a piezoelectrically and pyroelectrically active or activatable oxide in a homogeneous solution of a fluoropolymer, selected among fluoro-homopolymers and copolymers and mixtures of different fluoro-homopolymers and/or copolymers in a high boiling point solvent, selected under solvents having a boiling point of above 180°C and/or a vapor pressure of below 3 hPa, wherein the suspension is obtainable by a method according to any one of the claims 5 to 10.

12. Use of a suspension according to claim 11 for the manufacture of a piezoelectric and pyroelectric layer.

13. Use according to claim 12, wherein the piezoelectric and pyroelectric layer is prepared by means of doctor blading or screen printing methods.


**Revendications**

1. Procédé pour la préparation d'une solution homogène d'un fluoropolymère, choisi parmi des homo- et copolymères fluorés et des mélanges de différents homo- et/ou copolymères fluorés, dans un solvant à haut point d'ébullition, dans lequel :

    (a) le fluoropolymère à dissoudre est dissous dans un mélange d'au moins deux solvants dont le premier présente un point d'ébullition inférieur à 150 °C et/ou une pression de vapeur supérieure à 5 hPa (à 20 °C) et dont le deuxième est un solvant à haut point d'ébullition qui présente un point d'ébullition supérieur d'au moins 50 °C à celui du premier solvant et/ou dont le point d'ébullition est choisi de telle façon que le mélange de solvants présente un coefficient de séparation $\alpha \geq 1$, et ensuite
    (b) le premier solvant est pratiquement ou complètement éliminé du mélange.

2. Procédé selon la revendication 1, dans lequel le premier solvant présente un point d'ébullition inférieur à 75 °C et/ou une pression de vapeur supérieure à 100 hPa (à 20 °C) et le deuxième solvant a un point d'ébullition supérieur à 180 °C et/ou une pression de vapeur inférieure à 3 hPa.

3. Procédé selon la revendication 1 ou 2, **caractérisé en ce que** les au moins deux solvants sont d'abord mélangés et le fluoropolymère à dissoudre est ajouté au mélange de solvants.

4. Procédé selon l'une quelconque des revendications précédentes, **caractérisé en ce que** le premier solvant est de l'acétone et **en ce que** le deuxième solvant est de la butyrolactone.

5. Procédé pour la préparation d'une suspension de particules inorganiques d'un oxyde actif ou activable piézoélectriquement et pyroélectriquement dans une solution homogène d'un fluoropolymère, choisi parmi des homo- et copolymères fluorés et des mélanges de différents homo- et/ou copolymères fluorés, dans un solvant à haut point d'ébullition, comprenant les étapes consistant à :

    (a) préparer une suspension de particules inorganiques dans un milieu de suspension,
    (b) dissoudre le fluoropolymère dans un mélange constitué d'au moins deux solvants, dont le premier présente un point d'ébullition inférieur à 150 °C et/ou une pression de vapeur supérieure à 5 hPa (à 20 °C) et dont le deuxième est un solvant à haut point d'ébullition présentant un point d'ébullition supérieur d'au moins 50 °C à celui du premier solvant et/ou dont le point d'ébullition est choisi de telle façon que le mélange de solvants présente un coefficient de séparation $\alpha \geq 1$,
    (c) ajouter la suspension de particules inorganiques à la solution de fluoropolymère selon le point (b) et
    (d) éliminer totalement ou partiellement le premier solvant et le milieu de suspension.

6. Procédé pour la préparation d'une suspension de particules inorganiques d'un oxyde actif ou activable piézoélectriquement et pyroélectriquement dans une solution homogène d'un fluoropolymère, choisi parmi des homo- et copolymères fluorés et des mélanges de différents homo- et/ou copolymères fluorés, dans un solvant à haut point d'ébullition, comprenant les étapes consistant à :

(a) préparer une suspension de particules inorganiques dans un milieu de suspension,
(b) préparer une solution de fluoropolymère selon l'une quelconque des revendications 1 à 5,
(c) ajouter la suspension de particules inorganiques à la solution de fluoropolymère selon le point (b) et
(d) éliminer totalement ou partiellement le milieu de suspension.

7. Procédé selon la revendication 5 ou la revendication 6, **caractérisé en ce que** le milieu de suspension présente un point d'ébullition inférieur à 120 °C, de préférence inférieur à 100 °C.

8. Procédé selon la revendication 7, **caractérisé en ce que** le milieu de suspension est choisi parmi les cétones aliphatiques ou des mélanges de cétones aliphatiques ou bien des mélanges d'un ou de plusieurs solvants avec des cétones aliphatiques.

9. Procédé selon la revendication 5, dans lequel le premier solvant présente un point d'ébullition inférieur à 75 °C et/ou une pression de vapeur supérieure à 100 hPa (à 20 °C) et le deuxième solvant a un point d'ébullition supérieur à 180 °C et/ou une pression de vapeur inférieure à 3 hPa.

10. Procédé selon la revendication 9, **caractérisé en ce que** le premier solvant est l'acétone, le deuxième solvant la butyrolactone et le milieu de suspension une cétone aliphatique ayant un point d'ébullition inférieur à 120 °C et est de préférence de la méthyléthylcétone.

11. Suspension incolore de particules inorganiques d'un oxyde actif ou activable piézoélectriquement et pyroélectriquement dans une solution homogène d'un fluoropolymère, choisi parmi des homo-et copolymères fluorés et des mélanges de différents homo- et/ou copolymères fluorés, dans un solvant à haut point d'ébullition, choisi parmi des solvants ayant un point d'ébullition supérieur à 180 °C et/ou une pression de vapeur inférieure à 3 hPa, la suspension pouvant être obtenue suivant un procédé selon l'une quelconque des revendications 5 à 10.

12. Utilisation d'une suspension selon la revendication 11 pour préparer une couche piézo- et pyroélectrique.

13. Utilisation selon la revendication 12, la couche piézo- et pyroélectrique étant formée au moyen d'un procédé d'enduction à la racle ou de sérigraphie.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1769544 A1

- EP 849298 A1

**In der Beschreibung aufgeführte Nicht-Patentliteratur**

- Ferroelectric Polymers and Ceramic-Polymer Composites. Trans Tech Publications Ltd, 1994
- **J. ZENG.** *Appl. Phys,* 2002, vol. 9, 2674-2679
- **DAS-GUPTA, A.A.O. ; L. JINHUA et al.** Preparation of PCLT/P(VDF-TrFE) pyroelectric sensor based on plastic film substrate. *Sensors and Actuators A,* 2002, vol. 100, 231-235
- **I. GRAZ et al.** Flexible active-matrix cells with selectively poled bifunctional polymerceramic nanocomposite for pressure and temperature sensing skin. *Journal of Applied Physics,* 2009, vol. 106, 034503
- **M. ZIRKL et al.** *Ferroelectrics,* 2007, vol. 353, 173-185

- **M. ZIRKL.** Herstellung und Charakterisierung von ferroelektrischen Polymer-Dünnfilmen und ihre Anwendung in integrierten organischen Infrarotsensoren. *Univ.-Diss. Graz,* 2007
- **TAZAKI et al.** *J. Appl. Polym. Sci.,* 1997, vol. 65 (8), 1517-1524
- **M. DIETZE et al.** *Sensors and Actuators A,* 2008, vol. 143, 329-334
- Paints, Coatings, and solvents. Wiley-VHC Verlag GmbH Weinheim, 1998
- **H.-S BYUN et al.** *Korean J. Chem. Eng.,* vol. 21 (6), 193-1198
- **K.I. ARSHAK et al.** *Sensors and Actuators,* 2000, vol. 79, 102-114
- **Y.H. SON et al.** *Integrated Ferroelectrics,* 2007, vol. 88, 44-50